Europäisches Patentamt

European Patent Office

Office européen des brevets

(11) Publication number: **0 180 430**
**A2**

## (12) EUROPEAN PATENT APPLICATION

(21) Application number: **85307740.2**

(22) Date of filing: **25.10.85**

(51) Int. Cl.⁴: **H 01 L 21/302, H 01 L 21/306**

(30) Priority: **25.10.84 US 664495**

(43) Date of publication of application: **07.05.86**
**Bulletin 86/19**

(84) Designated Contracting States: **AT BE CH DE FR GB IT
LI LU NL SE**

(71) Applicant: **TANDEM COMPUTERS INCORPORATED,
19333 Vallco Parkway, Cupertino California 95014 (US)**

(72) Inventor: **Hoss, Paul-Andre, 1199 Bernardo Avenue,
Sunnyvale California 94087 (US)**

(74) Representative: **Beresford, Keith Denis Lewis et al,
R.G.C. Jenkins & Co. 12-15, Fetter Lane, London
EC4A 1PL (GB)**

(54) A process of reducing a wafer size.

(57) A process of reducing the size of a wafer is provided without damaging the remaining wafer surface. A flat is cut on a partially fabricated wafer within the desired diameter of a reduced size wafer. The edges of the wafer are sandblasted to reduce the wafer's diameter to approximately the desired diameter of the reduced size wafer. The reduced sized wafer is etched to repair wafer damage caused by the cutting and sandblasting steps.

Λ

## FIELD OF THE INVENTION

The present invention relates to wafers used in the semiconductor industry and, more particularly, to a process of reducing the size of a wafer.

## BACKGROUND OF THE INVENTION

Often, during production of a final wafer product on a wafer fabrication line, the supply of the wafer size being used on the line becomes exhausted. If that particular wafer size is not in stock or readily available, the production line is shutdown until that wafer size is obtained because it is typically too costly to redesign and refit the production line for another wafer size. Thus, valuable and expensive production time is lost during this shutdown.

Similarly, it is not possible, by presently known techniques, to solve this supply problem by merely cutting a larger wafer to the desired wafer diameter due to the excessive mechanical damage that occurs to the wafer. Likewise, the grinding down of the edges of the wafer is tedious and too time-consuming to maintain production efficiencies. Thus, the wafer fabrication line must remain idle while awaiting a supply of new wafers, even if large supplies of other size wafers are on hand.

Moreover, the reduced size wafer must be produced to appear indistinguishable from a new wafer of the same size to a machine interacting with the wafer. Otherwise, if the reduced size wafer

-1-

could be distinguished, the machine may not properly interact with the reduced size wafer. Rejection of the reduced size wafer on the fabrication line causes delay and necessitates the individual replacement of the rejected wafers.

## SUMMARY OF THE INVENTION

Therefore, a main objective of the present invention is a wafer size reducing process that overcomes the aforementioned drawbacks.

It is a more specific objective of the present invention to produce a reduced size wafer that is indistinguishable from a new wafer that is of the same size.

It is also an objective of the present invention to minimize the shutdown time of a wafer fabrication line.

It is a further objective of the present invention to produce reduced size wafers that are ready for further processing.

Additional objectives and advantages of the invention will be set forth in the description that follows and, in part, will be apparent from the description, or may be learned by practice of the invention. The objectives and advantages of the invention may be realized and obtained by means of instrumentalities and combinations particularly pointed out in the appended claims.

To achieve these and other objectives, the present invention provides a process of reducing the size of a wafer comprising the steps of: cutting a flat on a wafer within the desired diameter

-2-

of a reduced size wafer; sandblasting the edges of the wafer to reduce the wafer's diameter approximately to the desired diameter; and etching the reduced size wafer to repair wafer damage caused by the cutting and sandblasting steps.

In another embodiment, the present process further includes performing the sandblasting of the wafer at an angle to the wafer base to remove the edge of the wafer at an angle. This sandblast angle and location is maintained to reduce the wafer base to the desired diameter of the reduced size wafer.

The present process overcomes the inherent disadvantages of previous wafer size reducing techniques, and meets the various objectives of the invention. Particularly, the present invention permits the easy conversion of larger, unused wafers to smaller, readily usable wafers. Thus, fabrication line shutdown time is minimized when the supply of a particular wafer size is depleted, since the present invention enables the convenient conversion of larger wafers into smaller wafers that can be used in the fabrication line. Not only is shutdown time lessened, but wafers of a size that is no longer desirable or usable are economically changed into wafers of the desired dimensions to avoid the wasteful disposal of the unused wafers.

The present process also produces reduced size wafers that are ready for further processing without the further modification of the wafer. The resulting wafer of the present process is indistinguishable to a machine using the wafer from a new wafer that is originally produced with those particular dimensions. In view of this indistinguishability, a fabrication line can interchangeably use, side-by-side, wafers reduced by the present process and new wafers originally cut to that size. Such interchangeability minimizes fabrication line interruptions that occur from depleted wafer supplies, since a variety of wafer sizes that are in supply can be altered to substitute for the desired wafer size.

As an illustration of the advantages of the present invention, without the present process, a fabrication line that is designed to use 4 inch diameter wafers is shutdown when the supply of 4 inch wafers at the plant is interrupted or depleted, even if another size wafer, such as 5 inch diameter wafers, is readily available. Costly machine and personnel time are wasted while awaiting the resupply of the 4 inch wafers. Switching the fabrication line to a different size wafer is often too costly, especially for anticipated interruptions of a few days to a week, and it does not allow for the continued production of the 4 inch wafers.

In contrast, the present process permits the conversion of the 5 inch diameter wafers that are in stock to the required 4 inch diameter wafers. Thus, the fabrication line can be maintained in full operation with the use of 4 inch wafers that are reduced from a 5 inch diameter by the present process. Even when a supply of new 4 inch diameter wafers is obtained, the 4 inch reduced size wafers can still be used in the same fabrication line with the new 4 inch wafers, because the wafers reduced by the present process are indistinguishable from the new wafers to a machine interacting with the reduced size wafers. Therefore, the fabrication line is maintained in maximum production as new and reduced sized wafers are used side by side in the line as supplies dictate.

## BRIEF DESCRIPTION OF THE DRAWINGS

The accompanying drawings, which are incorporated in and constitute a part of the specification, illustrate at least one embodiment of the invention and, together with the description, serve to explain the principles of the invention.

Figure 1 is a view of a larger size wafer that is reduced to a smaller size wafer by the present process.

Figure 2 is a schematic side cross-sectional view of a wafer being reduced in size by sandblasting.

## DESCRIPTION OF THE PREFERRED EMBODIMENT

The present invention provides a process of reducing the size of a wafer. In the present method, a flat is cut on a wafer within the desired diameter of the reduced size wafer. The wafer can be fabricated, partially fabricated, or blank. The edges of the wafer are sandblasted to reduce the wafer's diameter to approximately the desired diameter of the reduced size wafer. The reduced size wafer is then etched to repair the wafer damage caused by the cutting and sandblasting steps.

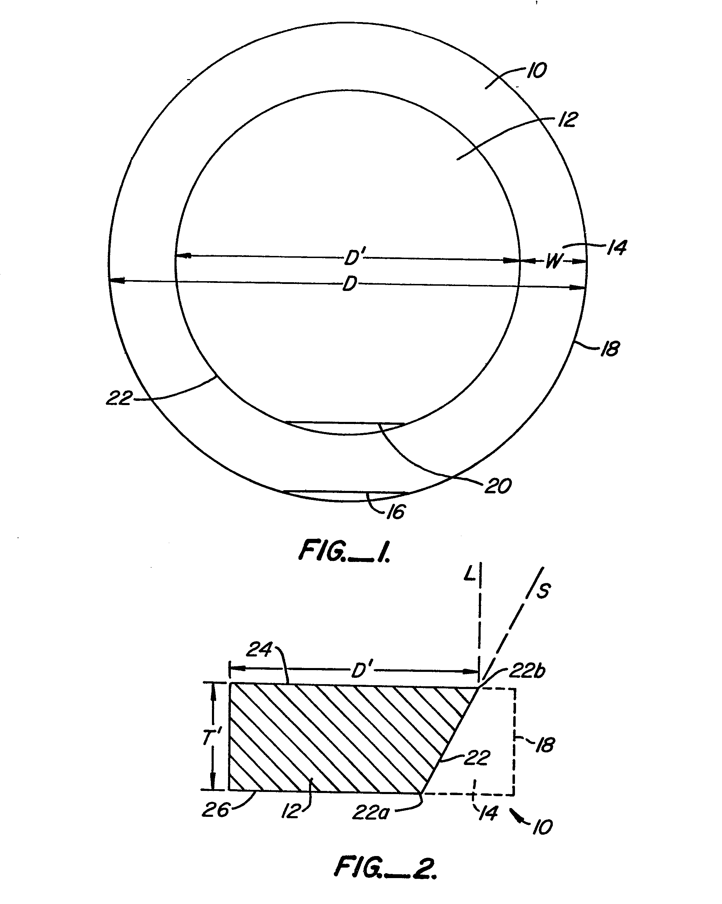

As shown in Figure 1, a wafer 10, having approximately a diameter D, is reduced in size by the present process to a reduced size wafer 12, having approximately a diameter D'. One-half of the difference D-D' between the two diameters is the width W of the ring 14 that is to be removed from the larger size wafer 10 to produce the smaller wafer 12.

As used herein, the term larger size wafer refers to a wafer before it is reduced in size by the present process. The partially fabricated wafer has a base side 24 and a side 26 that can be fabricated to contain the circuitry of the wafer 10. The term reduced size wafer refers to the wafer after it is reduced in size by the present process. Hence, the reduced size wafer 12 was originally part of the larger size wafer 10.

The wafer 10 has a flat 16 cut into the surface of the wafer 10 near an edge 18 of the wafer 10. In use, the flat 16 interacts with a machine using the wafer 10 to align and identify the wafer 10. Hence, the proper positioning of the flat 16 on the wafer 10 is important to allow the machine to react quickly and easily with the wafer.

The original flat 16 of the wafer 10 is on the ring portion 14 of the wafer 10 that is to be removed by the present process in reducing the diameter of the wafer 10 from D to D' to produce the wafer 12. As a result, a new flat 20 must be positioned and cut within the diameter D' of the wafer 12. The flat 20 is formed near the edge 22 of the reduced size wafer 12. In one method, the flat 20 is positioned and cut by aligning a cutting instrument, such as a diamond saw, with the larger size wafer 10. A new wafer, having the diameter D' and a flat already properly positioned, is used as a guide to determine where the flat 20 is to be positioned on the reduced wafer 12. After making the calculations, which are within the skill of the artisan, the skilled worker moves the diamond saw to the appropriate position on the wafer 12 to cut the flat 20. The flat 20 can be completely cut into the wafer 20 or its position can be marked or scribed for later cutting. The flat can be cut before or after the sandblasting step.

After the flat 20 is scribed or cut, the edges 18 of the larger wafer 10 are sandblasted to reduce the wafer's diameter from D to D' and to yield the wafer 12 having edges 22. Preferably, as shown in Figure 2, the sandblasting S is performed at an angle to the wafer 10 to remove the original edge 18 of the wafer 10 at an angle. As a result, the edge 22 of the reduced size wafer 12 is formed at an angle. The angle of the sandblast is maintained to reduce the reduced wafer edge 22b of the base 24 of the wafer to approximately the desired diameter D' of the reduced size wafer 12. Thus, the base 24 of the reduced size wafer 12 has the desired diameter D' and the fabricated side 26 of the wafer 12, having the various circuits 28, has a diameter slightly smaller than D', depending upon the sandblast angle and the thickness T of the wafer 12.

By cutting the edge 22 at an angle, the cross section curvature at the edge 22 of the resulting wafer 12 is controlled. Various defects in the central portion of the edge 22 are hidden from the machine interracting with the wafer 12, because it is the edge 22b at the wafer base 24, having the diameter D', that interacts with the machine. The central portion of the edge, which may contain mechanical defects, is not as carefully inspected by the machine. The base portion 24 of the wafer 12 is selected to have the diameter D' because the fabricated side 26 of the wafer 12 contains the various circuitry 28 of the wafer 12 and, hence, it is easier to round off the base edge 22b to enable it to interact readily with the machine. To achieve the proper edge cut, preferably, the angle of sandblasting is 30° to 80° with respect to a line L perpendicular to the base 24 of the wafer 12, as depicted in Figure 2.

Various mechanisms can be used to perform the sandblasting. In the preferred process, a jet sandblasting technique is used.

preferably, the wafer 12 is placed on a rotating chuck during the sandblasting operation to rotate the wafer with respect to a jet sandblaster. A typical rotating chuck useful in this operation is sold under the trademark SWAM-B by Crystal Mark Corp. in Glendale, California. A typical jet sandblaster capable of rendering the proper edge cut on the wafer is sold under the trademark MODEL-H ABRASIVE UNIT by S.S. White in New Jersey.

After the reduced size wafer 12 has been reproduced by sandblasting, the reduced wafer 12 is etched to repair wafer damage caused by the cutting and sandblasting steps. Since the edge 22a near the fabrication side 26 of the wafer 12 is rougher than the edge 22b near the base 24, the fabrication side edge 22a does not etch as evenly as the base edge 22b. An appropriate etch is a silicon etch as conventionally used in the art. Since such a silicon etch usually reduces the wafer diameter by about 2 to 3 mils, the sandblasting procedure is performed so that the diameter of the base 24 of the reduced size wafer 12 after sandblasting is about 2 to 3 mils greater than the desired diameter D'. After etching, the diameter of the wafer 12 is the desired diameter D'.

After the sandblasting step, the reduced size wafer 12 is preferably cleaned to remove from the wafer undesirable debris caused by the sandblaster. An acceptable cleaning tecnnique is the use of deionized water with light brushing.

*10*

Prior to the cutting and sandblasting procedures, various protective means can be applied to the wafer, particularly to the fabricated side 26 of the wafer 10. Since the typical wafer 10, which is reduced in size by the present process, is a finished or semi-finished wafer, such as a mirrored or a diffused wafer, it is preferred that the circuits on the wafer are protected during the present process.

Acceptable protective means include one or more coats of a photoresist layer or one or more strips of tape on the fabricated side 26 of the wafer. The photoresist layer can be either positive or negative so long as it survives the physical steps of the present process. An acceptable tape is a vinyl tape or teflon tape that has a mild adhesive coating that does not leave deposits when the tape is removed. The tape also holds the reduced wafer 12 and the ring 14 together until all of the various cutting and sandblasting techniques are completed. For added protection, both a photoresist layer and a tape layer can be used in conjunction. The photoresist layer and tape layer are removed, preferably, after the etching step to expose the fabricated surface.

To make it easier to operate on the wafer 10 during the present process, the wafer 10 is mounted on a fixture, preferably plastic. Such a fixture centers the wafer 10 while the sandblasting procedure is being performed to prevent the wafer from becoming off centered.

In addition to the wafer 10 having a diameter D that is larger than the needed diameter D', the wafer 10 can also have a thickness T that is larger than the desired thickness T'. Thus, the thickness T of the wafer 10 must also be reduced to render the reduced wafer 12 interchangeable with new wafers on the fabrication line. It is not sufficient for the wafer merely to have the desired diameter D', but the thickness of the reduced wafer 12 must also be the acceptable thickness T', as shown in Figure 2.

One procedure of reducing the thickness of the wafer 12 is by grinding the wafer base 24. Preferably, a precision diamond grinding apparatus, such as the one sold under the trademark MPS-2-R300 by Georg Muller GMBH in Nurenberg, West Germany, may be used to remove the excess mils of thickness from the wafer to yield the wafer thickness T'. Alternatively, a lapping apparatus, such as the one sold under the trademark LAPMASTER by Morton Grove, a division of Crane Packing Co. in Illinois, may be used to reduce the thickness. The grinding technique is preferred, however, because it causes less mechanical damage to the wafer 12 than the lapping technique. As a result of less mechanical damage, the grinding technique produces a smoother finish on the wafer base 24 and, hence, it is more likely that the reduced size wafer 12 will be handled interchangeably with the new wafers of that diameter and thickness by the wafer handling equipment.

12

The apparatus used to perform the present process includes various cutters, sandblasters, grinders, rotating chucks, and etchers that would be known to one skilled in the art. The apparatus, as well as the construction and assembly of the apparatus, depend upon the type and size of the wafer being reduced. However, the apparatus, construction, and assembly are to be selected to be consistent with the description of the process, including the various operational parameters.

It will be apparent to those skilled in the art that various other modifications and variations could be made in the process of the invention, without parting from the scope or the content of the invention.

CLAIMS:

1.  A process of reducing the size of a wafer comprising the steps of:

(a)  cutting a flat on a wafer within the desired diameter of a reduced size wafer;

(b)  sandblasting the edges of the wafer to reduce the wafer's diameter to approximately the desired diameter of the reduced sized wafer; and

(c)  etching the reduced sized wafer to repair wafer damage caused by the cutting and sandblasting steps.

2.  The process of claim 1, wherein the sandblasting is performed at an angle to the wafer base to remove the edge of the wafer at an angle.

3.  The process of claim 2, wherein the sandblast angle and location is maintained to reduce the wafer base to the desired diameter.

4.  The process of claim 2, wherein the angle of sandblasting is 30° to 80° with respect to a line perpendicular to the wafer base.

5.  The process of claim 1, wherein the wafer is rotated during the sandblasting step.

6.  The process of claim 1, wherein the sandblasting is performed with a jet sandblaster.

-13-

7. The process of claim 1, further comprising the step of applying a protective means to a fabricated side of the wafer.

8. The process of claim 7, wherein the protective means is one or more photoresist layers on the fabricated side of the wafer.

9. The process of claim 7, wherein the protective means is one or more strips of tape on the fabricated side of the wafer.

10. The process of claim 1, further comprising the step of cleaning the wafer after the sandblasting step.

11. The process of claim 1, further comprising the step of reducing the thickness of the wafer.

12. The process of claim 11, wherein the thickness of the wafer is reduced by grinding the base of the wafer.

13. The process of claim 11, wherein the thickness of the wafer is reduced by lapping the base of the wafer.

14. The process of claim 1, wherein the wafer is etched with a silicon etch.

15. A process of reducing the size of a partially fabricated wafer comprising the steps of:

(a) applying a protective means to a fabricated side of a partially fabricated wafer;

(b) cutting a flat on the wafer within the desired diameter of a reduced size wafer;

(c) sandblasting the edges of the partially fabricated wafer to reduce the wafer's diameter to approximately the desired diameter of the reduced size wafer, the sandblasting being performed at an angle to the wafer base to remove the edge of the wafer at an angle and to reduce the wafer base to the desired diameter of the reduced size wafer; and

d) etching the reduced size wafer to repair wafer damage caused by the cutting and the sandblasting steps.

16. The process of claim 15, wherein the wafer is rotated during the sandblasting step.

17. The process of claim 15, further comprising the step of reducing the thickness of the wafer.

18. The process of claim 16, wherein the thickness is reduced by grinding the base of the wafer.

19. The process of claim 15, wherein the protective means is one or more photoresist layers on the fabricated side of the wafer.

FIG._1.

FIG._2.